# EUROPEAN PATENT APPLICATION

(11) **EP 4 012 753 A1**
(43) Date of publication of application: **15.06.2022**
(21) Application number: 20212521.7
(22) Date of filing: 08.12.2020
(51) Int. Cl.: H01L 21/60, H01L 25/07, H01L 25/03, H01L 23/538, H01L 23/495

(54) **SEMICONDUCTOR DEVICE, SEMICONDUCTOR MODULE AND MANUFACTURING METHOD**

(71) Applicant: Hitachi Energy Switzerland AG, 5400 Baden (CH)
(72) Inventor: Salvatore, Giovanni, 34170 Gorizia (IT); Pavlicek, Niko, 8041 Zürich (CH); Mohn, Fabian, 5408 Ennetbaden (CH)
(74) Representative: Epping - Hermann - Fischer

(57) **Abstract**

In one embodiment, the semiconductor device (1) comprises:
- a semiconductor chip (2) having a chip top side (20),
- a cover body (23) which is electrically insulating and which houses the semiconductor chip (2), and
- cover body contacts (60) at a cover body top side (26) remote from the semiconductor chip (2) and in electric contact with the semiconductor chip (2),
wherein the cover body contacts (60) and the cover body (23) together to protect the semiconductor chip (2),
wherein the cover body contacts (60) are configured for welding.

A power semiconductor module (1) comprises:
- at least one such chip-sized packaged semiconductor device (1), and
- a plurality of contact pieces (3) which are electrically conductive,
wherein the contact pieces (3) and the assigned cover body contact (60) are connected by means of welding seams (36).

## Description

A semiconductor device and a power semiconductor module comprising such a semiconductor device are provided. A method for manufacturing such a power semiconductor module is also provided.

Document C. Marczok et al., "Low Inductive SiC Mold Module with Direct Cooling", PCIM Europe Conference 2019: International Exhibition and Conference for Power Electronics, Intelligent Motion, Renewable Energy and Energy Management, May 7, 2019 to May 9, 2019, Nuremberg, Germany, discusses chip-sized packages for semiconductor chips.

Document US 2008/0211070 A1 refers to a flip-chip contact power package.

Document CN 103 996 666 A relates to a power semiconductor device and a manufacturing method of the power semiconductor device.

A problem to be solved is to provide a power semiconductor module that can be used for high voltages and that can efficiently be manufactured.

The exemplary embodiment of the disclosure addresses the above shortcomings inter alia, by a semiconductor device, by a power semiconductor module and by a method as defined in the independent patent claims. Exemplary further developments constitute the subject-matter of the dependent claims.

For example, the power semiconductor module comprises a plurality of semiconductor devices, for example, chip-sized semiconductor devices, each of which includes a semiconductor chip. To enable the power semiconductor module to be efficiently electrically contacted, contact pieces are welded onto the semiconductor devices, and the semiconductor devices are configured to enable welding, like laser welding.

In at least one embodiment, the semiconductor device for the power semiconductor module comprises:
- at least one semiconductor chip configured, for example, for voltages of at least 0.4 kV, the semiconductor chip may comprise at least one chip top contact on a chip top side the at least one chip top contact is configured for welding, for example, for laser welding, and
- an electrically insulating cover body in which the semiconductor chip is placed and which houses the semiconductor chip, at least in part, and which is, for example, configured to protect the semiconductor chip against mechanical and/or thermal damage during, for example, a welding process like laser welding.

In at least one embodiment, the semiconductor device for the power semiconductor module comprises:
- a semiconductor chip configured for voltages of at least 0.4 kV, the semiconductor chip has a chip top side,
- a cover body which is electrically insulating and in which the semiconductor chip is placed, and
- cover body contacts at a cover body top side remote from the semiconductor chip and in electric contact with the semiconductor chip,
wherein the chip top side is completely or almost completely covered by the cover body contacts together with the cover body to protect the semiconductor chip,
wherein the cover body contacts are configured for welding.

According to at least one embodiment, the cover body contacts are configured for welding, like laser welding. Hence, a material composition and a geometry of the cover body contacts are chosen in such a way that welding is enabled.

According to at least one embodiment, a size of the cover body contacts is in each case at least 1.0 x 1.0 mm² or at least 0.5 x 0.5 mm², seen in top view of the cover body top side. As an option, this size is at most 10 x 10 mm².

According to at least one embodiment, a thickness of the cover body contacts is at least 5 µm or is at least 50 µm or is at least 80 µm or at least 100 µm. As an option, this thickness is at most 0.5 mm or at most 0.2 mm. Hence, the cover body contacts are comparably thick to allow the laser welding, for example.

According to at least one embodiment, the cover body contacts comprise at least one of Cu and Al. For example, the cover body contacts comprise or consist of Cu or of a Cu alloy. It is possible, that the cover body contacts are of multi-layer fashion; in this case, it is possible that at least one of the layers of the cover body contacts comprise or consist of Cu or of a Cu alloy, for example, a topmost layer facing away from the assigned semiconductor chip.

The chip top side may be a main side of the at least one semiconductor chip, that is, a largest side. The chip top contact or the top contacts can be realized, for example, by metallizations applied to a semiconductor body of the semiconductor chip. Hence, the at least one chip top contact is configured to feed current into the semiconductor body. In addition to the at least one chip top contact, there can be one or more additional chip contacts, for example, on a chip bottom side opposite the chip top side.

According to at least one embodiment, the cover body completely covers the chip top side together with the cover body contacts and/or the top contacts. That is, the cover body can be a protective layer at the chip top side and optionally at chip side faces. Accordingly, protection of the semiconductor chip against mechanical damage or contamination or thermal load due to a welding step like laser welding can be provided.

The cover body can be a molded or casted body. Further, embedding technology can be used so that the cover body can be produced by lamination of, for example, one or of multiple prepreg layers, for example, comprising FR4. For example, the cover body is of a polymer like an epoxy, optionally together with at least one metall. The term 'prepreg' means pre-impregnated and refers, for example, to composite fibers where a thermoset polymer matrix material, such as epoxy, or a thermoplastic resin is already present around the fibers. The fibers may take the form of a weave and the matrix is used to bond them together and to other components during manufacture. At first, the thermoset matrix is only partially cured to allow easy handling. Hence, using a prepreg allows one to impregnate the fibers on a flat workable surface, or rather in an industrial process, and then later form the impregnated fibers to a shape which could otherwise prove to be problematic.

According to at least one embodiment, the cover body is made of an inorganic material like a glass or a ceramic. Hence, outgassing of the cover body at elevated temperatures, for example, during welding can be avoided. For example, the cover body is made of silicon dioxide or aluminum nitride.

According to at least one embodiment, a thickness of the cover body is at least 2 µm or at least 5 µm or at least 20 µm. Alternatively or additionally, said thickness is at most 2 mm or at most 1 mm or at most 0.5 mm or at most 0.1 mm. If the cover body is of an organic and/or polymeric material, then the cover body thickness is, for example, between 40 µm and 2 mm inclusive. If the cover body is of an inorganic material like a glass or ceramic, then the cover body thickness is, for example, between 2 µm and 40 µm inclusive. By means of such a thickness, the cover body can efficiently provide mechanical and/or thermal protection to the semiconductor chip.

According to at least one embodiment, if the semiconductor chip comprises the chip top contacts, there are contact pedestals, for example, vias, that may run completely through the cover body from the chip top contacts to the cover body contacts. Hence, the contact pedestals can be metallizations formed by, for example, sputtering and subsequent plating. The contact pedestals may be formed in holes previously created in the cover body by, for example, drilling like laser drilling. Otherwise, the contact pedestals can be premanufactured metallic bodies bonded to the respective semiconductor chip and then embedded in the cover body by casting or molding.

According to at least one embodiment, seen in top view of the chip top side, the contact pedestals are completely located within the respective chip top contact. Hence, the contact pedestals can be limited to the chip top side and do not laterally project beyond the chip top side. 'Laterally' may refer to a direction in parallel with the chip top side. 'Top view' does not require the respective face to be indeed visible, but may primarily refer to a line-of-sight, for example, to a projection along a direction perpendicular with the chip top side.

Accordingly, a fan-out could properly be done in order to be able to scale-up the maximum possible voltage. That is, by using a conductive layer or sub-layer atop the contact pedestals, for example, the cover body contacts, an intermediate wiring can be realized so that an area of an electric wiring and/or a size of the electric top contacts as present directly on the chip top side can be expanded. Hence, for example, a gate pad of the semiconductor chip can be made larger atop the cover body by reducing the area of other electric contacts on the chip top side towards atop the cover body.

However, also atop the cover body the cover body contacts are, for example, completely located within the chip top side, seen in top view of the chip top side. Moreover, the cover body contacts may not proceed closer towards outer edges of the chip top side or towards outer edges of the cover body than the chip top contacts of the semiconductor chip, seen in top view, proceed towards the outer edges of the chip top side. For example, the cover body contacts do not exceed the respective chip top contact in the direction of the edge of the chip top side so as not to overlap with a chip termination area, seen in top view of the chip top side.

According to at least one embodiment, the cover body is configured to provide thermal protection to the semiconductor chip during, for example, welding like laser welding to mount the contact pieces. This applies, for example, if there are the contact pedestals. Hence, by means of the cover body a thermal resistance between the cover body contacts and the semiconductor chip can be increased. Thus, lower thermal load needs to be applied to the cover body contacts to achieve the welding.

According to at least one embodiment, the at least one semiconductor is selected from the following group: a metal-oxide-semiconductor field-effect transistor (MOSFET), a metal-insulator-semiconductor field-effect transistor (MISFET), an insulated-gate bipolar transistor (IGBT), a bipolar junction transistor (BJT), a thyristor, a gate turn-off thyristor (GTO), a gate commutated thyristor (GCT), a junction gate field-effect transistor (JFET), and a diode. If there is a plurality of the semiconductor chips, then all the semiconductor chips can be of the same type, or there are different types of semiconductor chips.

A power semiconductor module is additionally provided. The power semiconductor module includes a semiconductor device as indicated in connection with at least one of the above-stated embodiments. Features of the power semiconductor module are therefore also disclosed for the semiconductor device and vice versa.

In at least one embodiment, the power semiconductor module comprises:
- one or a plurality of the semiconductor devices,
- optionally a substrate on which the at least one semiconductor device is mounted, and
- a plurality of contact pieces which are electrically conductive, wherein the contact pieces and the assigned cover body contacts are connected by means of welding seams, for example, by means of laser welding seams.

Welding is a fabrication process that joins materials, in the present case usually metals, by using high heat to melt the parts together and allowing them to cool, causing fusion. Welding is distinct from lower temperature metal-joining techniques such as brazing and soldering, which do not melt the base metal. In addition to melting the at least one base metal, a filler material could be added to the joint to form a pool of molten material, the weld pool, that cools to form a joint that, based on weld configuration, can be stronger than the at least one base material. Pressure may also be used in conjunction with heat. For example, the heat source is a laser like an infrared or ultraviolet laser.

Thus, the welding seam, also referred to as joint, allows to unambiguously determine that the device has indeed been welded and has not been soldered or adhesively bonded, for example.

Thus, the present application may refer to a power semiconductor module with laser-bonded chip-scale-packaged semiconductor devices.

Accordingly, for example, a novel power module concept based on chip-scale-packages, CSP, of power semiconductor devices in combination with laser-bonded leadframe-based top-side connection concepts is described, enabling higher performance, like increased current rating of the semiconductors, better switching performance and more compact power modules. The application of CSP embedded semiconductor devices provides mechanical protection during the laser welding process and enables a fan-out pad layout to facilitate laser welding also for a relatively small gate pad.

During assembly, the contact pieces, like leadframes, are placed with high precision on the prepackaged chips on a power module substrate and welded by means of, for example, a focused laser beam. Leadframe-based top-side connections can replace a multitude of thick wire bonds. Additionally, the leadframes may also act as power terminals and signal connections. Stamped leadframes and flexible circuits can be mass-produced at low cost, and significant savings of expensive ceramic substrate area can be realized with the power semiconductor module described herein.

Semiconductor chips, like IGBTs, MOSFETs or diodes, used in power semiconductor modules are typically vertical devices. Hence, current flows from the top-side source/emitter contact to the bottom-side drain/collector contact. For example, a full area of the chip's bottom-side is bonded, like soldered or sintered, to a top-metallization layer of a substrate like a ceramic substrate.

Recent research in power electronics heavily focuses on replacing Si devices by wide-bandgap devices made from SiC or GaN because of lower losses. However, the replacement of Si IGBTs with SiC/GaN MOSFETs poses some technological challenges. One of the most prominent is the increased current densities, that is, less chip area is available to accommodate the required number of typically used wire bonds for a given current. Consequently, wire bonding technology reaches its limits with regards to current capability. A possible solution is replacing Al wires with Cu wires; however, heavy Cu wire bonding requires bond buffer plates adding an additional process step and cost or novel, robust top metallization technologies of the semiconductor chips.

Laser welding as used herein to replace bond wires may require a minimum metallization thickness, for example, of Cu, of 100 µm to achieve a stable process, which is far thicker than typical Al-based top-side metallization layers on power semiconductors used for wire bonding.

Hence, in the power semiconductor module described herein, for example, a gate connection can be realized by contact piece instead of an Al wire bonded to the gate pad of the semiconductor chip. Thus, the same interconnection process can be used for all cover body top contacts which promises more compact power semiconductor module layouts for higher switching speeds.

Chip-scale packaging (CSP) originates from conventional PCB manufacturing and has been conceived for the integration of miniaturized and heterogeneous microelectronic/optical components, also called System in Package or SiP, mostly for consumer electronics. However, in the semiconductor devices described herein this approach has been extended to the packaging of semiconductor devices up to a voltage class of at least 1.2 kV, for example. Higher voltage classes could also be realized by using thicker insulation layers and/or other insulation materials for the cover body.

CSP offers various advantages over TO-like, QFN and other surface mounted packages like better heat extraction, no-wire bonding and lower parasitics, and provides an alternative route to the assembly of power semiconductor modules, for example, in a cleanroom-less manner. One aspect is the design freedom to fan-out chip top contacts and to integrate multi-layer signal routing to any shape and complexity as needed. This allows to realize low-inductance interconnects, to integrate sensors and controllers with a multitude of I/O channels, and to realize ultra-compact packages without the need of wire bonds leading to flat layouts and geometries beneficial also for double side-cooled designs. Moreover, the embedding of the semiconductor chip into a polymeric layer, for example, of FR4 or an epoxy, for the cover body and a proper design of the top metallization, that is, of the cover body contacts, provides a mechanical protection for post-processing, like sintering, soldering or welding processes.

As mentioned in the previous section, the semiconductor devices described herein tackle, for example, the following limitations in the construction of the power semiconductor modules:
i) A maximum current capability of wide-bandgap semiconductor devices based, for example, on SiC or GaN, with high current densities is limited by the source wire bonds due to size limitations. The required multitude of thick bond wires per module limits the manufacturing throughput per wire bonder equipment and the reliability of power modules since wire bond failures, like lift-off or heel cracks, are among the dominant failure mechanisms.
ii) In addition, precious substrate area is wasted for low-current gate and auxiliary signals that could be guided on cheaper alternatives.
iii) The replacement of wire bonds by clips, ribbons, pins, leadframes, which can enable more compact power semiconductor module designs with lower parasitc inductances is challenging because of the limited available size of the chip pads, for example, for source, gate, drain, that are becoming smaller and smaller because of chip miniaturization. This limitation is particularly evident in the case of the gate pads.

In the power semiconductor modules described herein, CSP technology can be used for the at least one semiconductor device to fan-out the chip top contacts, also referred to as bond pads, for example, for gate, source, drain and auxiliary, of the semiconductor chip and to enable laser welding of the terminals, leadframes or pins for the contact pieces directly onto the cover body contacts of the pre-packaged semiconductor chip. Proper design of the CSP semiconductor device can ensure proper mechanical protection of the semiconductor chip during the welding and can avoid additional processing steps, like soldering or sintering of top plates onto the semiconductor chip. Additionally, the CSP technology enables the top contacting of the emitter/drain contact. Further, the contact to the CSP-packaged devices can be established by a pin or a clip as the contact piece.

The laser welding process may be realized either with a welding robot or a welding jig, or using a laser bonder equipment. The latter option removes the necessity to develop a complex welding jig because the bond tool doubles as a holding-down clamp.

The power semiconductor module described herein substantially reduces the cost of power modules at a given power rating for the following reasons, for example:
- The cost of the substrate can be reduced without compromising heat spreading.
- Since the substrate area is reduced, the footprint of the fully assembled power semiconductor module, including mold encapsulation or housing, in turn reduces. This leads to additional cost savings of mold compound or housing.
- At the same time, the reliability of the power semiconductor modules potentially increases because the dominant failure source of wire bonds is mitigated.
- The CSP enables a baseplate-less design and cleanroom-less assembly reducing the manufacturing costs.
- Additional design freedom and improved electrical characteristics are enabled by multilayer coplanar current routing.

In summary, as the semiconductor device, a CSP pre-package with bond pads large enough for laser welding is provided, wherein the CSP pre-package may comprise
- a semiconductor chip, like a MOSFET, an IGBT or diode, and made from Si, SiC, GaN, diamond GaO, or the like, and bonded to a substrate, which may comprise an insulating layer so that it is a direct bonded copper substrate, DBC, an active metal braze substrate, AMB, or an insulated metal substrate, IMS, etc.) or which is of a metal, like a leadframe, and
- an encapsulation, that is, the cover body, made from an insulating material, like an epoxy or FR4.

In summary the, power semiconductor module may be a multichip power module comprising at least two CSP pre-packages as stated above and laser-welded terminals or interconnections, that is, the contact pieces, bonded to the pads of the CSP, that is, to the cover body contacts, and the terminals or interconnections may be, for example, leadframe terminals or a PCB. As the spacer body, an insulating encapsulation material, like a silicone gel, epoxy mold compound, potting compound, may be present between the PCB and the CSPs. The CSP packages, that is, the semiconductor devices, may be provided with non-insulated chip carriers and may be assembled on the insulating substrate, like a DBC, an AMB or an IMS, or on a baseplate, or directly onto a cooler. The insulating substrate may be bonded to a baseplate, or the baseplate is bonded to a heat sink or a cooler. Otherwise, CSP packages with non-insulating chip carriers are bonded on a substrate that is, for example, a baseplate, a heat sink or a cooler, with an insulating layer, or CSP packages with insulating chip carriers are bonded to a substrate that is, for example, the baseplate, the heat sink or the cooler. Laser-welded leadframes can be used for an interconnection of power and auxiliary signals from the multiple CSP pre-packaged semiconductor chips to metallization layers of the insulated substrate and/or to external terminals of the power semiconductor module.

In summary, an assembly or possible manufacturing process of the power semiconductor modules comprises first bonding the CSP onto the substrate, and then laser welding the terminals or interconnections and then assembling of the remaining parts, like a heatsink, a baseplate or a PCB.

According to at least one embodiment, the cover body contacts are the chip top contacts, too. That is, there can be thick metallizations that run from the chip top side to the cover body top side. In this case, the cover body does not need to be a casted or molded body, but the cover body can be a passivation layer produced, for example, by means of spin coating, evaporation or chemical vapor phase deposition.

According to at least one embodiment, at least one, some or all of the contact pieces are selected from the following group: leadframe, pin, clip, spring, stud bump. Hence, the contact pieces can be metallic pieces of the afore-mentioned categories welded onto the cover body contacts.

According to at least one embodiment, the power semiconductor module further comprises a circuit board, like a printed circuit board, PCB for short. In this case it is possible that at least one, some or all of the contact pieces are electric contact faces of the circuit board that is attached to the at least one semiconductor device.

The term 'power semiconductor module' means, for example, that the module is configured for high currents and/or voltages. For example, the at least one semiconductor device and/or the power semiconductor module is configured to handle a maximum current of at least 1 A or of at least 10 A or of at least 100 A or of at least 500 A. Alternatively or additionally, the at least one semiconductor device and/or the power semiconductor module is configured for voltages of at least 0.4 kV or of at least 0.6 kV or of at least 1.2 kV or of at least 2 kV.

According to at least one embodiment, the semiconductor device is a chip-sized package device, that is, a CSP device. Hence, a footprint of the semiconductor device is, for example, at most twice or thrice a footprint of the at least one semiconductor chip included in the semiconductor device, seen in top view of the at least one chip top side.

According to at least one embodiment, the optional spacer body is arranged in direct contact with the at least one cover body. Otherwise, there may be an intermediate layer between the cover body and the spacer body, for example, a metallic layer or a metallic layer stack. Optionally, the spacer body is of constant thickness in an area atop the cover body.

According to at least one embodiment, the contact pieces are in direct contact with the spacer body. The contact pieces may completely run through the spacer body. It is possible that the contact pieces are limited to the assigned semiconductor chip, seen in top view of the respective chip top side.

According to at least one embodiment, the cover body of the at least one semiconductor device is made of a prepreg. Hence, the cover body may comprise a fiber reinforcement embedded in an organic material.

According to at least one embodiment, the power semiconductor module is configured to be externally electrically contacted by means of the circuit board. That is, the power semiconductor module may be electrically contacted only by means of the circuit board. The only external faces of the power semiconductor module in electric contact with the at least one semiconductor chip may therefore be on the circuit board. Such external faces can be realized by, for example, metallic electric terminals.

According to at least one embodiment, the circuit board partially or completely covers the at least one semiconductor device and/or the spacer body, seen in top view of the at least one chip top side. The spacer body and the circuit board could be congruent with each other. The at least one semiconductor device can be completely surrounded by the circuit board and/or by the spacer body, seen in top view of the chip top side.

According to at least one embodiment, the circuit board further comprises electric lines. The electric terminals can be electrically connected to the contact pieces by means of the electric lines. It is possible that the electric terminals are electrically directly connected with the electric lines to the contact pieces. Otherwise, there may be at least one intermediate electronics like an integrated circuit for control and/or sensor purposes between the contact pieces and the electric terminals.

According to at least one embodiment, some of the contact pieces together are electrically assigned to only one of the chip top contacts. Hence, the respective chip top contact or the respective chip top contacts are electrically connected by a plurality of the contact pieces.

According to at least one embodiment, seen in top view of the at least one chip top side, the contact pieces are completely located within the chip top contact or within the cover body contact they are assigned to. Thus, small footprints can be realized.

All the contact pieces can be of the same type. Otherwise, different types of contact pieces can be combined within the power semiconductor module.

According to at least one embodiment, a thickness of the spacer body atop the at least one chip top side is at least 0.2 mm or at least 0.4 mm and/or at most 2 mm or at most 5 mm. Hence, by using the contact pieces, comparably thick spacer bodies can be achieved.

According to at least one embodiment, the at least one semiconductor device comprises a chip carrier, the chip carrier has a first electrically conductive carrier layer and the at least on semiconductor chip is conductively connected on the first electrically conductive carrier layer. The first electrically conductive carrier layer projects beyond the at least one assigned semiconductor device, seen in top view of the at least one chip top side. The chip carrier and the cover body may terminate flush with one another.

According to at least one embodiment, an additional contact pedestal runs from the first electrically conductive carrier layer through the cover body distant from the semiconductor chip to the cover body top side and is in electric contact with at least one of the cover body contacts. By means of such a contact pedestal, the chip carrier can be used for wiring.

According to at least one embodiment, the chip carrier further comprises an electrically insulating carrier layer. For example, the electrically insulating carrier layer separates the first electrically conductive carrier layer from the substrate.

According to at least one embodiment, seen in a cross-sectional view perpendicular to the cover body top side, at least one of the contact pieces is of L-shape. Hence, said contact piece comprises a first region in parallel with the cover body top side and a second region perpendicular to the cover body top side. The terms 'parallel' and 'perpendicular' may apply with a tolerance of at most 30° of at most 15° or of at most 5°. The respective welding seam connects the first region and the assigned cover body contact.

According to at least one embodiment, at least one of the contact pieces comprises a coating. The coating may be configured as an anti-reflection layer for laser radiation used for laser welding, for example. The coating can be of at least one metal like Ni. A thickness of the coating is, for example, at least 0.1 µm and/or at most 10 µm. The coating can be limited to locations of the contact piece exposed to the laser radiation. Otherwise, said at least one contact piece may completely be provided with the coating on all surfaces. In other words, the coating is an anti-refection coating. Thus, a reflectivity of the coating for the laser radiation is less than a corresponding reflectivity of a base material of the respective contact piece, said base material may be Cu.

According to at least one embodiment, at least one or some or all of the contact pieces are configured for an electrical plug-in connection to electrically contact the at least one assigned semiconductor chip. For example, the respective contact pieces can be plugged in a PCB. It is possible that in addition to the plug-in there is another contact technique like soldering.

According to at least one embodiment, the power semiconductor module comprises a plurality of the semiconductor devices. For example, there are at least two or at least four or at least eight of the semiconductor devices. Alternatively or additionally, there are at most 40 or at most 20 or at most twelve of the semiconductor devices. Seen in top view of the chip top sides, the semiconductor devices may be arranged next to one another in a non-overlapping manner.

According to at least one embodiment, all the semiconductor devices are covered by the one spacer body. For example, all the semiconductor devices are embedded between the substrate and the spacer body.

The power semiconductor module is, for example, a power module to convert direct current from a battery to alternating current for an electric motor, for example, in vehicles like hybrid vehicles or plug-in electric vehicles.

A method for manufacturing the power semiconductor module is additionally provided. By means of the method, a power semiconductor module is produced as indicated in connection with at least one of the above-stated embodiments. Features of the power semiconductor module are therefore also disclosed for the method and vice versa.

In at least one embodiment, the method is for manufacturing the power semiconductor module and comprises the following method steps, for example, in the stated order:
A) Providing the at least one semiconductor device, and
B) Bonding the contact pieces to the cover body contacts by means of laser welding.

A semiconductor device, a power semiconductor module and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic sectional view of an exemplary embodiment of a semiconductor device described herein,
- Figure 2: is a schematic sectional view in parallel with a chip top side of an exemplary embodiment of a semiconductor device described herein,
- Figure 3: is a schematic top view of an exemplary embodiment of a semiconductor device described herein,
- Figure 4: is a schematic sectional view of an exemplary embodiment of a semiconductor device described herein,
- Figure 5: is a schematic sectional view of a method step of exemplary embodiment of a manufacturing method for semiconductor device described herein,
- Figures 6 to 9: are schematic sectional views exemplary embodiments of power semiconductor modules described herein, and
- Figure 10: is a schematic perspective view of an exemplary embodiment of a power semiconductor module described herein.

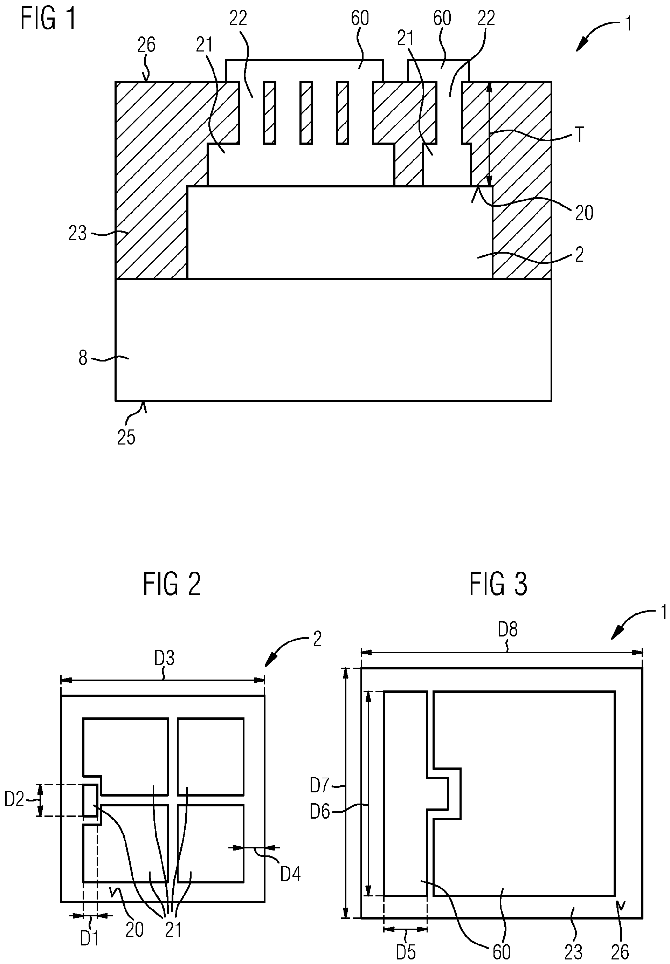

Figure 1 illustrate an exemplary embodiment of a semiconductor device 1. The semiconductor device 1 comprises a semiconductor chip 2 that is, for example, a MOSFET, a MISFET, an IGBT, a BJT, a GTO, a GCT, or a JFET. The semiconductor chip 2 can be a high voltage class chip and may be configured for voltages of at least 0.4 kV or of at least 1.2 kV. The semiconductor device 1 may contain only one semiconductor chip 2 as shown in Figure 1, but there can also be a plurality of semiconductor chips 2, for example, at most five semiconductor chips 2, of the same or also of different types.

Moreover, the semiconductor device 1 contains a cover body 23. For example, the cover body 23 is a prepreg or a molded body containing a polymer like an epoxy. The cover body 23 is in direct contact with chip side walls and also with a chip top side 20. A thickness T of the cover body 23 atop the chip top side 20 is, for example, 0.1 mm. Contact pedestals 22 run through the cover body 23.

At the chip top side 20, there are chip top contacts 21, also referred to as bond pads. The chip top contacts 21 can be metallizations in direct contact with a semiconductor body of the semiconductor chip 2. The chip top contacts 21 can have different sizes and/or silhouettes. The contact pedestals 22 start from the chip top contacts 21. There can be more than one contact pedestal 22 per chip top contact 21. As an option, the larger chip top contact 21, for example, a source or drain contact, is provided with a plurality of the contact pedestals 22, while the smaller chip top contact 21, for example, a gate contact, is provided with only one contact pedestal 22. Deviating from Figure 1, there can also be three or more than three chip top contacts 21, or also only one chip top contact 21.

The contact pedestals 22 can be manufactured by drilling holes into the previously finished cover body 23, for example, by laser drilling. Then, a metal seed layer may be sputtered, not shown. Then, by means of, for example, plating the holes are filled and the contact pedestals 22, also referred to as vias, result.

As an alternative, the contact pedestals 22 can first be bonded to the chip top side 20 and subsequently the cover body 23 is formed, for example, by means of molding. In this case, the contact pedestals 22 can be metal bodies mounted on the respective contact area 21 by soldering or sintering.

On a cover body top side 26 of the cover body 23 remote from the semiconductor chip 2, there are cover body contacts 60. The cover body contacts 60 are in each case a metallic layer or also a metallic layer stack. The cover body contacts 60project above the cover body 23.

The chip top contacts 21 can be comparably thin, for example, having a thickness of at least 1 µm and at most 10 µm. Contrary to that, the cover body contacts 60 can be relatively thick and can have, for example, a thickness of at least 80 µm and/or of at most 250 µm.

For example, the cover body contacts 60 are electrically structured analogously to the chip top contacts 21. Hence, per chip top contact 21 there can be exactly one cover body contact 60. However, the respective cover body contact 60and the assigned chip top contact 21 may have different footprints, compare also Figures 2 and 3.

In the exemplarily embodiment of Figure 2, there are five chip top contacts 21 of different sizes. For example, the smallest chip top contact 21 is for a gate contact and the four larger chip top contacts 21 are for source and/or drain contacts or for source and/or collector contacts.

Dimensions D1, D2, D3 of the chip top contacts 21 and of the chip top side 20, seen in top view of the chip top side 20, are, for example, 0.3 mm, 0.7 mm and 4.8 mm, respectively. An edge region of the chip top side 20 around the chip top contacts 21 and free of the chip top contacts 21 has a width D4 of, for example, at least 0.5 mm.

According to Figure 3, on the cover body top side 26 of the semiconductor device of Figure 2 the cover body contacts 60 have a different shape and have different sizes than the chip top contacts 21. For example, dimensions D5, D6, D7, D8 of the cover body contacts 60 and of the cover body top side 26 are 1.5 mm, 4.8 mm, 6.8 mm and 7.5 mm, respectively.

The dimensions D1-D8 as stated in the previous paragraphs may apply to all exemplary embodiments, for example, with a tolerance of at most a factor of 3 or of at most a factor of 1.5.

Hence, by means of the contact pedestals 22 and the cover body contacts 60 contact faces can be formed which do not necessarily have the shapes and/or sizes of the chip top contacts 21. However, contact faces formed by the cover body contacts 60 may have a minimum distance towards edges of cover body 23 that is or is at least a minimum distance towards edges of the chip top side 20 of the chip top contacts 21, seen in top view. In other words, seen in top view of the chip top contacts 21, the cover body contacts 60 are more distant than, or at most as distant as, the respective chip top contact 21 towards the edges of the chip top side 20. In particular, as in Figures 2 and 3, an outer contour of the cover body contacts 60 is congruent with the chip top side 20. Thus, the semiconductor device 1 can be configured for voltages of up to, for example, 1.7 kV.

By means of the large thickness of the cover body contacts 60 and by having a size of the cover body contacts 60 of, for example, at least 1 x 1 mm² when seen in top view of the cover body top side, the cover body contacts 60 are suitable for laser welding.

The semiconductor device 1 can be a chip-sized package, CSP for short. Hence, lateral dimensions of the overall semiconductor device 1 are comparable with lateral dimensions of the semiconductor chip 2. Lateral may mean a direction in parallel with the cover body top side 26. For example, a width of the cover body 23 at the side walls of the semiconductor chip 2 is at most 50% or at most 25% of an edge length of the chip top side 20. The edge length of the chip top side 20 is, for example, at least 1 mm or at least 2 mm and/or at most 2 cm or at most 1 cm. Seen in top view, the semiconductor chip 2 and/or the cover body 23 can have a rectangular or square shape.

Optionally, the semiconductor device 1 includes a chip carrier 8 at which the at least one semiconductor chip 2 is mounted, for example, by means of soldering or sintering. The chip carrier 8 can be a metallic leadframe, for example, made of copper or a copper alloy. A thickness of the chip carrier 8 is, for example, at least 0.1 mm and/or at most 1 mm. In the lateral direction, the chip carrier 8 may terminate flush with the cover body 23. A device bottom side 25 remote from the cover body top side 26 can thus be formed by the chip carrier 8. The chip carrier 8 can be an electric contact of the semiconductor device 1.

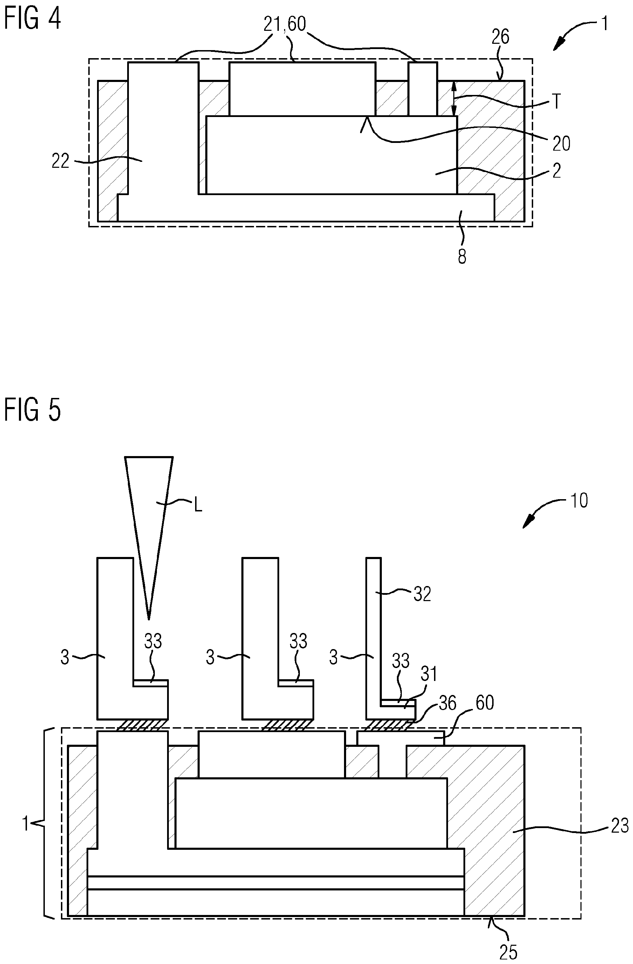

In Figure 4, another exemplary embodiment of the semiconductor device 1 is illustrated. In this case, the cover body 23 does not need to be a molded or casted body but can alternatively be produced from a gas phase. Thus, the thickness T may be at least 1 µm and/or at most 0.1 mm. Accordingly, there is no need for contact pedestals, and the chip top contacts 21 and the respective cover body contacts 60 may even be formed in each case of one piece.

For example, the chip top contacts 21 terminate flush with the cover body top side 26 and the cover body contacts 60 are applied atop the cover body top side 26. It is possible that the cover body contacts 60 extend on the cover body top side 26 and, hence, cover the cover body 23 in part.

This design without contact pedestals atop the chip top side 20 can also be used in all other exemplary embodiments.

As an option, the chip carrier 8 can laterally protrude the semiconductor chip 2. For example, the chip carrier 8 is a leadframe. Hence, next to the semiconductor chip 2 there can be the contact pedestal 22 running through the cover body 26 and being connected to one of the cover body contacts 60. Thus, the semiconductor device 1 can be a flip-chip device. The same applies to all other exemplary embodiments.

Otherwise, the same as to Figures 1 to 3 may also apply for Figure 4.

In Figure 5 a manufacturing method for a power semiconductor module 10 is illustrated. The module 10 comprises at least one semiconductor device 1, for example, a chip-sized package device. As an option, the module 10 comprises a substrate, not shown, on which the at least one semiconductor device 1 is mounted.

First, the at least one semiconductor device 1 comprising the cover body contacts 60 is provided. Second, by means of focused laser radiation L, contact pieces 3 are laser welded onto the cover body contacts 60. Therefore, the laser radiation L heats the contact pieces 3 as well as the cover body contacts 60 so that the contact pieces 3 and the cover body contacts 60 melt at their respective surfaces. Thus, during cooling, a welding seam 36 forms and the contact pieces 3 and the cover body contacts 60 are connected together. During welding, the semiconductor chip 2 is mechanically and/or thermally protected by the cover body 23, and the cover body 23 can also protect the semiconductor chip 2 against contaminations created by welding.

For example, the contact pieces 3 are leadframes or leadframe parts. Alternatively, the contact pieces 3 can also be pins or clamps or springs, not shown.

For example, the contact pieces 3 each have a first region 31 in parallel with the cover body top side 26 and second region 32 perpendicular to the cover body top side 26. Thus, the contact pieces 3 can be L-shaped seen in cross-section. For example, in this case the contact pieces 3 are leadframes.

As an option, there can be thicker contact pieces 3 configured for drain and source contacts, for example, and there can be a thinner contact piece 3 for a gate contact. Hence, the dimensions of the contact pieces 3 can be adapted to the electric load they are intended for.

As a further option, there can be a coating 33 at least on a side of the contact pieces 3 facing away from the at least one semiconductor device 1. For example, the coating 33 is limited to a top surface of the first regions 31 remote from the welding seam 36 where the laser radiation L is focused on. The coating 33 may be a plating to reduce the reflection of the incoming laser radiation L. Ni-plating is one possible implementation. Such a coating 33 can also be present in all other exemplary embodiments.

For example, as illustrated in Figure 5, the chip carrier 8 comprises a first electrically conductive carrier layer 81, an electrically insulating carrier layer 82 and a second electrically conductive carrier layer 83. Hence, the chip carrier 8 can be a DBC substrate. By means of such a chip carrier 8, the semiconductor chip 2 can be electrically insulated from the device bottom side 25. Such a chip carrier 8 can be used in all other exemplary embodiments, too. Of course, instead of the semiconductor device 1 as shown in Figure 5 also the semiconductor devices of Figures 1 to 4 can be used.

Although in Figure 5 laser welding is used, other kinds of welding may also be applied.

Otherwise, the same as to Figures 1 to 4 may also apply for Figure 5.

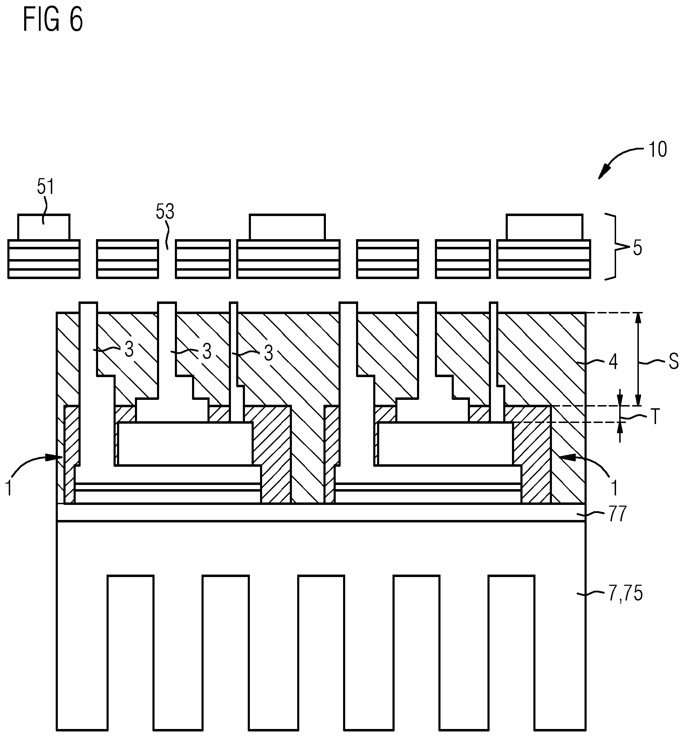

Figure 6 shows a power semiconductor module 10 with the laser-welded contact pieces 3 onto two CSP semiconductor devices 1, for example, for a high-side and low-side of a half-bridge inverter. In this case, the chip pre-package comprises the electrically insulating chip carrier 8, for example, a DBC substrate, an AMB substrate or an IMS. The semiconductor devices may be configured as illustrated in Figure 5.

Moreover, the module 10 can include a circuit board 5, in Figure 6 shown in a not yet fully mounted state. The circuit board 5 can comprise electric lines, not shown, between electric intakes 53 for the contact pieces 3 and electric terminals 51 to externally contact the circuit board 5. Such a construction enables top contacting of the semiconductor devices 1 with a power PCB for power and signal re-routing.

For example, the circuit board 5 is connected to the semiconductor devices 1 by plugging the contact pieces 3 into the electric intakes 53. This step may optionally be followed by another contacting step like soldering.

As an option, the semiconductor devices 1 are mounted on a heat sink 77 that could serve as a substrate 7 and that could be a cooler, too. The semiconductor devices 1 can be connected to the substrate 7 by means of a bonding layer 77 which is established, for example, by means of soldering, sintering or gluing. Such a substrate 7 and such a bonding layer 77 can be present in all other exemplary embodiments, too.

As a further option, the power semiconductor module 10 comprises a spacer body 4. The spacer body 4 is, for example, of a silicone gel or also of a plastic like epoxy. The spacer body 4 might be manufactured by casting or molding. Moreover, the spacer body 4 has a comparably large thickness S that effectively adds to the thickness T of the cover body 23. The spacer body 4 may be directly bonded onto the cover body 23. For example, the thickness S of the spacer body 4 is between 0.2 mm and 3 mm inclusive or between 0.3 mm and 2 mm inclusive. The contact pieces 3 protrude from the spacer body 4. It is possible that the spacer body 4 itself may serve as the substrate 7 if mechanically stable enough so that the heat sink 75 and/or the circuit board 5 may be omitted.

Otherwise, the same as to Figures 1 to 5 may also apply for Figure 6.

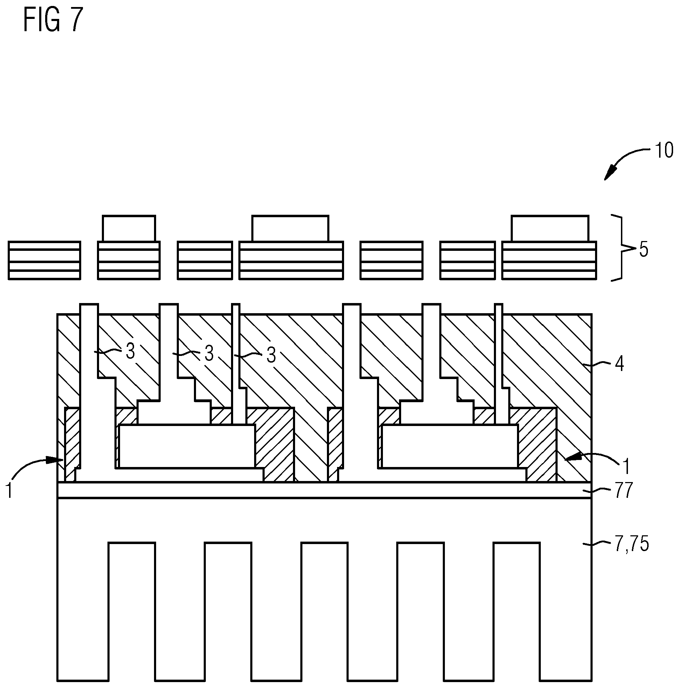

According to Figure 7, the semiconductor devices 1 comprise the conductive chip carrier 8, for example, a leadframe. Hence, in order to prevent electric shorts, the heat sink 75 is bonded to the semiconductor devices 1 by means of the electrically insulating bonding layer 77, for example, a thermal interface material, TIM for short.

Otherwise, the same as to Figure 6 may apply for Figure 7.

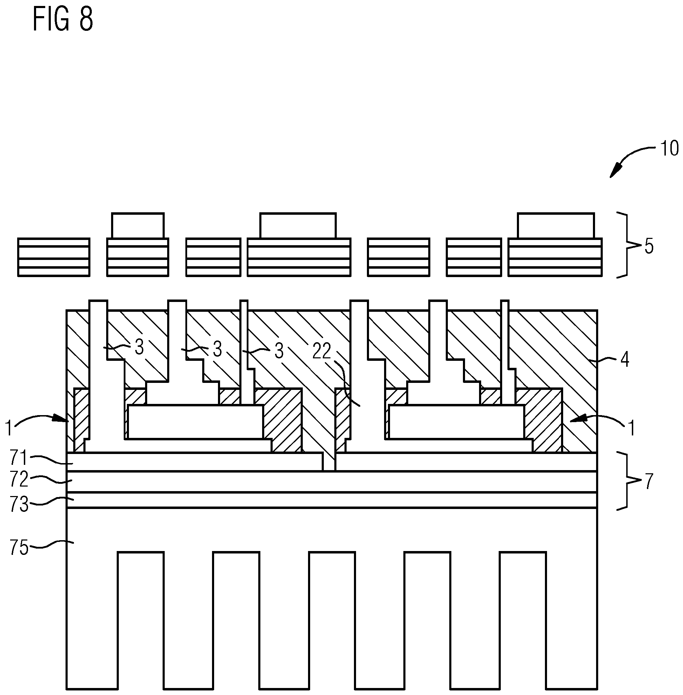

According to Figure 8, the substrate 7 for the semiconductor devices 1 is a DBC substrate. Hence, the substrate 7 comprises a top metallization 71, an intermediate insulating layer 72, for example, of a ceramic material, and a bottom metallization 75 connected to the optional heat sink 75. Hence, by means of the substrate 7 the semiconductor devices 1 are electrically insulated from the heat sink 75.

Otherwise, the same as to Figures 6 and 7 may also apply for Figure 8.

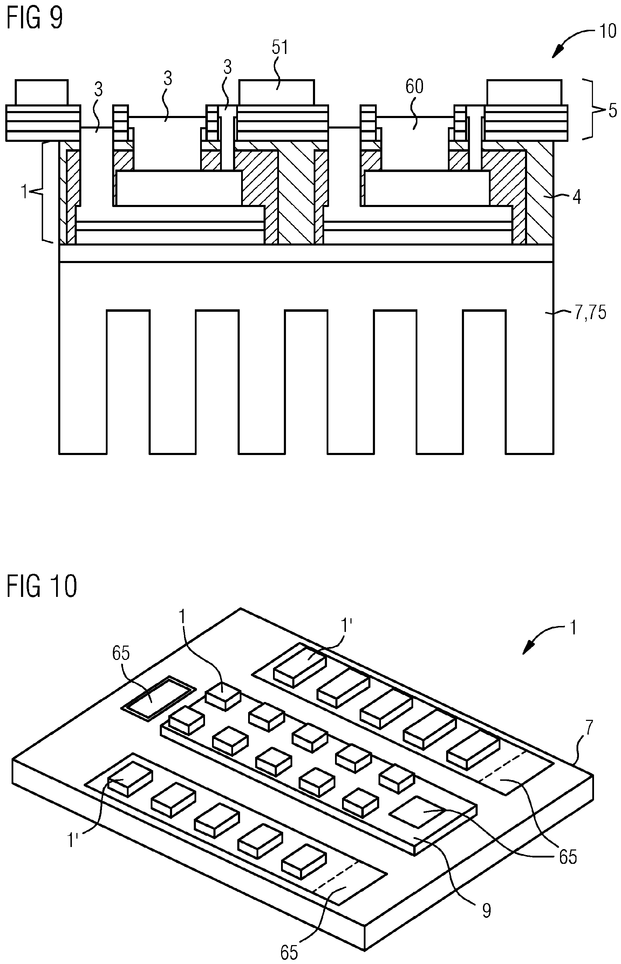

In the exemplary embodiment of Figure 9, the circuit board 5 itself comprises the contact pieces 3. That is, the contact pieces 3 can be an integral part of the circuit board 5. Hence, the circuit board 5 may touch the cover bodies 23 or the chip top contacts 21, or a distance between the circuit board 5 and the cover bodies 23 or the chip top contacts 21 is at most 0.1 mm or at most 0.2 mm, for example.

In other word, the thick metal PCB 5 is directly laser-welded onto the CSP prepackage semiconductor devices 1. This further simplifies the assembly because it renders any intermediate power/signal terminals unnecessary. Moreover, it would also reduce the required volume of the module 10.

As an option a semiconductor device 1 like in Figure 1 may be used with one bottom contact not led to the cover body top side 26. In this case, there may be a contact pedestal, not shown, running from the top metallization 71 to the cover body top side 26 so that the substrate 7 could be used for wiring, too. The same applies to all other exemplary embodiments of the module 10.

Otherwise, the same as to Figures 6 to 8 may also apply for Figure 9.

Another exemplary embodiment of the module 10 is shown in Figure 10. To simplify the drawing, the contact pieces and the circuit board, or the circuit boards, are not shown in Figure 10.

According to Figure 10, there is a plurality of the semiconductor devices 1 which are, for example, power devices. Further, there are additional semiconductor devices 1', for example, control devices that do not bear significant electric power compared with the semiconductor devices 1. As an option, the semiconductor devices 1 can be bonded to an auxiliary carrier 9. There can be a plurality of additional contacts 65 on the substrate 7 and on the auxiliary carrier 9. For example, the semiconductor devices 1 on the auxiliary carrier 9 and the contact 65 in elongation of the auxiliary carrier 9 are provided with contact pieces for high currents whereas the additional semiconductor devices 1' and the other contacts 65 are provided with contact pieces for low power, like the right-most contact piece 3 in Figure 6 for a gate contact.

Hence, there can be a plurality of circuit boards, not shown, configured for high power and low power, respectively, to connect the devices 1, 1'. Otherwise, there is only one circuit board comprising the wiring for all the devices 1, 1'. Hence, with the concept described herein a complex wiring can be realized while keeping electrical connecting efficient.

That is, there can be a leadframe-based interconnection of power signals, and gate and other auxiliary signal connections can be realized as laser-bonded contact pieces, too. This enables a very compact power semiconductor module design, for example, for automotive applications using multiple cheap laser-bonded leadframes for the contact pieces, eliminating the need for wire bonds and even terminal bonding if the contact pieces are also used for the external terminal connections at the same time.

Otherwise, the same as to Figures 1 to 9 applies for Figure 10.

The exemplary embodiments described in this disclosure are not restricted by the description given with reference to the exemplary embodiments. Rather, it is contemplated that the disclosure encompasses any novel feature and any combination of features, including in particular any combination of features in the claims, even if this feature or this combination is not itself explicitly indicated in the claims or exemplary embodiments.

### List of Reference Signs

- 1: semiconductor device
- 1': additional semiconductor device
- 10: power semiconductor module
- 2: semiconductor chip
- 20: chip top side
- 21: chip top contact
- 22: contact pedestal
- 23: cover body
- 25: device bottom side
- 26: cover body top side
- 3: contact piece
- 31: first region
- 32: second region
- 33: coating
- 36: welding seam
- 4: spacer body
- 5: circuit board
- 51: electric terminal
- 53: electric intake
- 60: cover body contact
- 65: additional contact
- 7: substrate
- 71: top metallization
- 72: insulating layer
- 73: bottom metallization
- 75: heat sink
- 77: bonding layer
- 8: chip carrier
- 81: first electrically conductive carrier layer
- 82: electrically insulating carrier layer
- 83: second electrically conductive carrier layer
- 9: auxiliary carrier
- D..: dimension
- L: laser radiation
- S: thickness of the spacer body atop the chip top side
- T: thickness of the cover body atop the chip top side

## Claims

1. A semiconductor device (1) comprising:
- a semiconductor chip (2) having a chip top side (20),
- a cover body (23) which is electrically insulating and which houses the semiconductor chip (2), and
- cover body contacts (60) at a cover body top side (26) remote from the semiconductor chip (2) and in electric contact with the semiconductor chip (2),
wherein the cover body contacts (60) and the cover body (23) together to protect the semiconductor chip (2),
wherein the cover body contacts (60) are configured for welding.

2. The semiconductor device (1) according to the preceding claim,
wherein at least one of
- the chip top side (20) is completely covered by the cover body contacts (60) together with the cover body (23) to protect the semiconductor chip (2),
- a dimension of at least one of the cover body contacts (60) comprises 0.5 x 0.5 mm²,
- a thickness of at least one the cover body contacts (60) is at least 80 µm,
- at least one of the cover body contacts (60) comprise at least one of Cu and Al, and
- a thickness of the cover body (23) above the chip top side (20) is at least 5 µm.

3. The semiconductor device (1) according to any one of the preceding claims,
wherein the semiconductor chip (2) comprises chip top contacts (21) on the chip top side (20), the chip top contacts (21) are electrically connected with the cover body contacts (60),
wherein at least one of the cover body contacts (60) is larger than the assigned chip top contact (21), wherein, seen in top view of the chip top side (20), the cover body contacts (60) are at least as distant to edges of the cover body (23) as the at least one assigned chip top contact (21) is distant to edges of the chip top side (20).

4. A power semiconductor module (10) comprising:
- at least one semiconductor device (1) according to any one of the preceding claims, and
- a plurality of contact pieces (3) which are electrically conductive,
wherein the contact pieces (3) and the assigned cover body contacts (60) are connected by means of welding seams (36).

5. The power semiconductor module (10) according to the preceding claim,
wherein at least one of the contact pieces (3) is selected from the following group: leadframe, pin, clip, spring, stud bump.

6. The power semiconductor module (10) according to claim 4,
further comprising a circuit board (5),
wherein at least one of the contact pieces (3) is an electric contact face (51) of the circuit board (5) that is attached to the at least one semiconductor device (1).

7. The power semiconductor module (10) according to any one of claims 4 to 6,
further comprising a spacer body (4) that is electrically insulating and that is arranged on the at least one cover body (23),
wherein the contact pieces (3) are at least partially located in the spacer body (4).

8. The power semiconductor module (10) according to the preceding claim,
wherein the cover body contacts (60) are all completely embedded between the at least one cover body (23) and the spacer body (4).

9. The power semiconductor module (10) according to any one of claims 4 to 8,
wherein at least one of the contact pieces (3) comprises a coating (33) at least on a side remote from the at least one semiconductor device (1),
wherein the coating (33) is an anti-refection coating.

10. The power semiconductor module (10) according to any one of claims 4 to 9,
wherein, at least one of the contact pieces (3) is of L-shape and comprises a first region (31) in parallel with the cover body top side (26) and a second region (32) perpendicular to the cover body top side (26), and
wherein the respective welding seam (36) connects the first region (31) and the assigned cover body contact (60).

11. The power semiconductor module (10) according to any one of claims 4 to 10,
wherein at least one of the contact pieces (3) is configured for an electrical plug-in connection to electrically contact the at least one assigned semiconductor chip (2).

12. The power semiconductor module (10) according to any one of claims 4 to 11,
wherein the at least one semiconductor device (1) comprises a chip carrier (24), the chip carrier (24) has a first electrically conductive carrier layer (81) and the at least on semiconductor chip (2) is conductively connected on the first electrically conductive carrier layer (81),
wherein the first electrically conductive carrier layer (81) projects beyond the at least one semiconductor device (1), seen in top view of the at least one chip top side (20), and
wherein a contact pedestal additional contact piece (22) runs from the first electrically conductive carrier layer (81) through the cover body (23) distant from the semiconductor chip (2) to the cover body top side (26) and is in electric contact with at least one of the cover body contacts (60).

13. The power semiconductor module (10) according to the preceding claim, ,
further comprising a substrate (7) on which the at least one semiconductor device (1) is mounted, wherein the chip carrier (24) of the at least one semiconductor device (1) further comprises an electrically insulating carrier layer (82) separating the first electrically conductive carrier layer (81) from the substrate (7).

14. The power semiconductor module (10) according to any one of claims 4 to 12,
further comprising a substrate (7), and
comprising a plurality of the semiconductor devices (1) mounted on the substrate (7), wherein, seen in top view of the chip top sides (20), the semiconductor devices (1) are arranged next to one another in a non-overlapping manner.

15. A method for manufacturing the power semiconductor module (10) according to any one of claims 4 to 14, the method comprises:
A) Providing the at least one semiconductor device (1), and
B) Bonding the contact pieces (3) to the cover body contacts (60) by means of welding.
